# EUROPEAN PATENT APPLICATION

(11) **EP 0 811 983 A1**
(43) Date of publication of application: **10.12.1997**
(21) Application number: 96830333.9
(22) Date of filing: 06.06.1996
(51) Int. Cl.: G11C 11/34, H01L 27/115, H01L 21/8247

(54) **Flash memory cell, electronic device comprising such a cell, and relative fabrication method**

(71) Applicant: SGS-THOMSON MICROELECTRONICS s.r.l., 20041 Agrate Brianza (Milano) (IT)
(72) Inventor: Baldi, Livio, 20041 Agrate Brianza (IT); Maurelli, Alfonso, 20050 Sulbiate (IT); Marangon, Santina, 20063 Cernusco Sul Naviglio (IT); Moroni, Maurizio, 20017 Rho (IT)
(74) Representative: Cerbaro, Elena

(57) **Abstract**

The device includes flash-EEPROM memory cells (80), circuit transistors (81, 82) and high-voltage transistors (83, 84); and a layer of salicide, i.e. self-aligned titanium silicide, is formed on and contacting the source and drain regions of the cells (80) and transistors (81-84) and on and contacting the control gate regions of the cells and the gate regions of the transistors. The salicide, which reduces the series resistance of the transistors and so improves performance of the circuit portion, in no way impairs the electric characteristics, reliability or cycling characteristics of the cells, thus enabling the formation of mixed devices with a high-performance logic portion and a high storage capacity.

## Description

The present invention relates to a flash memory cell, an electronic device comprising such a cell, and a relative fabrication method.

As is known, in the fabrication of logic devices, use is now commonly made of a layer of self-aligned titanium silicide (known as "salicide") to reduce the resistivity of the junctions, which is formed by depositing a layer of titanium over the entire surface of the device, and heating to cause the titanium to react with the silicon left exposed on the junctions and gate regions, and so form titanium silicide (TiSi₂) in these regions. The nonreacting titanium is then removed from the silicon-oxide-covered regions of the device by etching with an appropriate solution, which leaves the titanium silicide intact, so that both the polycrystalline silicon gate regions and the junctions have in parallel a low-resistivity (about 3-4 Ω/□) TiSi₂ layer to reduce the series resistance of the transistors, short the source regions of the transistors with the substrate contacts with no need for metal connections, and so permit greater freedom in the location of the transistor contacts. The salicide process is described, for example, in the Article entitled "Application of the self-aligned titanium silicide process to very large-scale integrated n-metal-oxide-semiconductor and complementary metal-oxide-semiconductor technologies" by R.A. Haken, in J. Vac. Sci. Technol. B, Vol. 3, No. 6, Nov/Dec 1985, and more recently in "Self-aligned silicidation for sub half micron technologies" by K. Maex, Conference Proceedings ULSI-X, 1995, p. 405-414.

Most leading manufacturers produce flash EEPROM memories using much the same process, which has undergone very little change in recent generations, and which provides for N⁺ junctions of arsenic (plus phosphorous for the source implant) and a gate region comprising a multilayer of doped polycrystalline silicon and chemical-vapor-deposed (CVD) tungsten silicide. No flash memories currently available on the market are produced using the salicide process, which, in the case of flash memories, seems to afford no advantage. Indeed, application of the salicide process to flash memories has up to now always been ruled out as a probable source of malfunctioning and unreliability, due to variations in series resistance, the mechanical stress introduced by formation of the salicide on the silicon or interpoly dielectric (separating the floating and control gate regions of flash cells), the various heat treatment steps required to form the salicide, which may impair the characteristics, particularly the charge retention capacity, of flash cells, in general, on account of the high degree of sensitivity shown by flash cells to even minor changes in process parameters.

On the other hand, the continual increase in integration density now poses the problem of integrating large nonvolatile memory blocks with complex high-performance logic circuits, in particular microprocessors and digital signal processors (DSP), to enable straightforward updating of system software or storage of new application-derived data.

Moreover, forgoing the salicide process in logic devices incorporating logic components and a flash memory portion results in speed and density problems as regards the logic portion of the device, and involves a certain amount of expense to redesign the logic portion itself.

On the other hand, not even mixed devices can be produced using the salicide process, wherein the memory portion is protected by a mask, in that, using current fabrication methods, the mask would also prevent the salicide layer being formed on the gate region of the transistors, thus resulting in access time problems in the case of medium-large (over 64 Kbit) memories. Nor is it possible to use memories with a particular configuration, e.g. wherein the control gate region fully surrounds the floating gate region, so that the salicide is actually prevented from being formed on the critical portion of the memory, in that the configurations so far proposed normally require a much larger area than standard memories and involve variations in electric characteristics (in some case, the memories are not erasable electrically).

It is an object of the present invention to provide a memory cell, an electronic device comprising such a memory cell, and a fabrication method, designed to overcome the aforementioned drawbacks by also enabling application of the salicide process to devices including a flash memory portion, and without impairing the electric characteristics, operation or reliability of the various parts of the device.

According to the present invention, there are provided a memory cell, an electronic device comprising such a cell, and a fabrication method, as claimed respectively in Claims 1, 4 and 5.

In practice, according to the invention, the salicide process is also used for the memory cell. This has required a number of changes to the method of fabricating the cell, to form the salicide, and of fabricating the logic portion, to form the cell itself. Tests have shown that, by appropriately calibrating the steps in the fabrication method, devices can be formed comprising both a logic portion and a flash memory portion, without impairing the present characteristics or performance of the two portions considered separately, so as to conform perfectly with current requirements for mixed complex logic applications.

A preferred, non-limiting embodiment of the present invention will be described by way of example with reference to the accompanying drawings, in which:

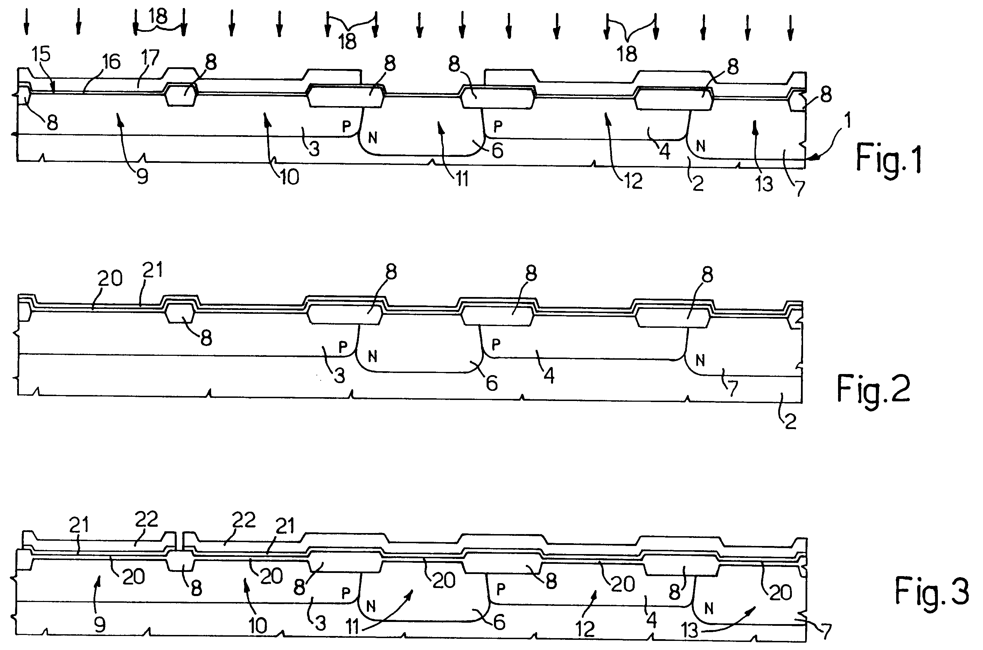

Figures 1 to 27 show cross sections of a portion of a silicon wafer at various steps in the fabrication of the device according to the present invention.

With the aid of the accompanying drawings, a preferred method of fabricating an electric device will be described, comprising a logic portion, a high-voltage portion, and a flash memory portion. In the drawings, the various layers are only shown entirely in the Figure corresponding to the step in which they are formed and otherwise; when not distinguishable from adjacent layers of the same chemical-electric characteristics, the layers are not shown separately; and the size, in particular the thickness, of the layers is not to scale.

Figure 1 shows a cross section of a silicon wafer 1 comprising a substrate 2 already subjected to conventional preliminary fabrication steps. More specifically, substrate 2 already presents P-wells 3 and 4; N-wells 6 and 7; and thick oxide field insulating regions 8 for insulating a memory region 9 in which the memory portion is to be formed, logic regions 10 and 11 in which respective N- and P-channel transistors forming part of the logic circuitry are to be formed, and high-voltage regions 12 and 13 in which respective high-voltage N- and P-channel transistors are to be formed.

Surface 15 of substrate 2 presents a sacrificial oxide layer 16, and a masking layer 17 covering the whole of layer 16 with the exception of region 11; and arrows 18 in Figure 1 indicate the dopant (e.g. boron and phosphorous) implant step to regulate the threshold voltage of the P-channel circuit transistors.

Sacrificial oxide layer 16 is then removed; a tunnel oxide layer 20 (about 10-12 nm thick) is grown; and a first polycrystalline silicon layer 21 (about 10-12 nm thick) is deposited (Figure 2). A masking layer 22 is deposited covering the whole of the logic and high-voltage portions (regions 10-13) and presenting windows (not shown) extending over memory region 9 and parallel to the drawing plane to separate the floating gate regions of the cells in a direction perpendicular to the drawing plane; and the exposed portion of first polycrystalline silicon layer 21 is removed (Figure 3). After removing mask 22, a dielectric layer (so-called "interpoly dielectric") 23 is grown or deposited (Figure 4). The interpoly dielectric may comprise a multiple ONO (silicon Oxide-Nitride-Oxide) layer to a total thickness of about 15-25 nm.

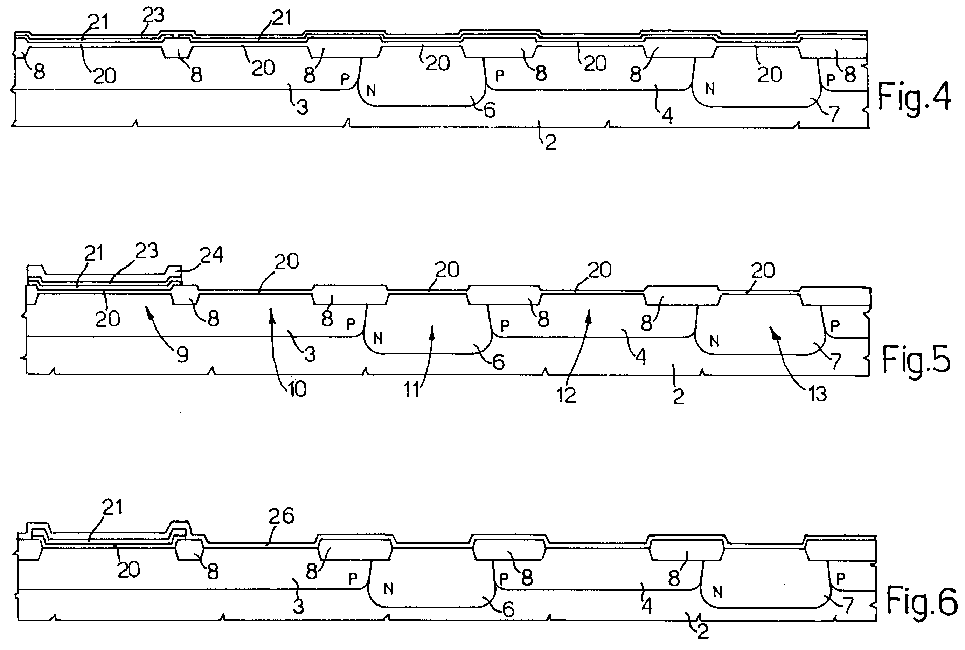

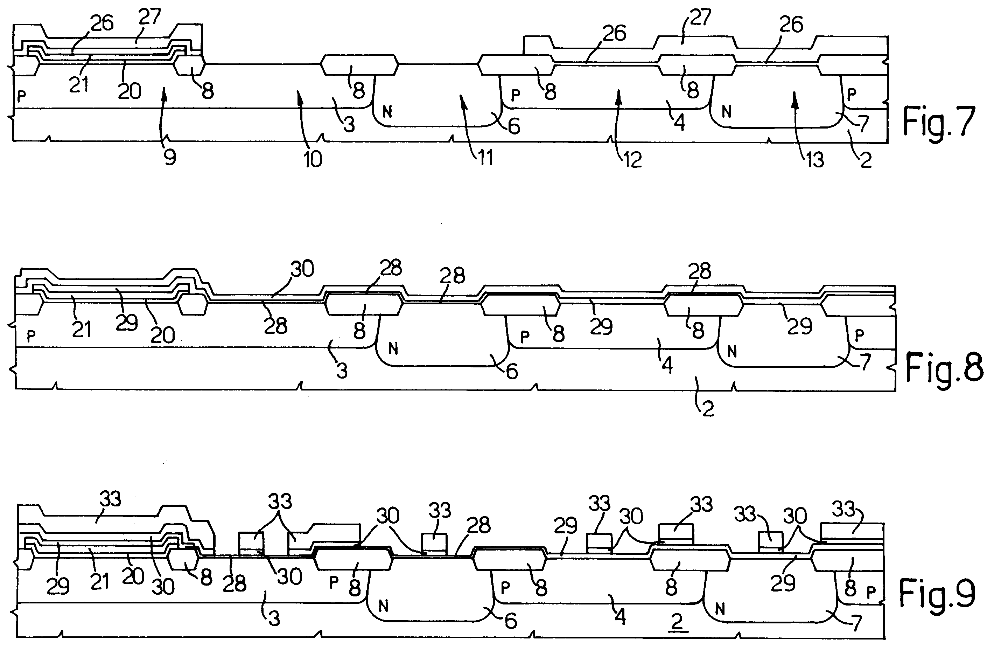

An array mask 24 is then formed covering the whole of array region 9; and the exposed portions of dielectric layer 23 and of first polycrystalline silicon layer 21 (over logic regions 10, 11 and high-voltage regions 12, 13) are removed (Figure 5). Wafer 1 is then washed to remove the exposed portions of tunnel oxide layer 20 (logic and high-voltage regions 10-13); and a first gate oxide layer 26 is grown (Figure 6). A masking layer 27 is then formed covering all the regions from which layer 26 is not to be removed (array region 9 and high-voltage regions 12, 13, where an insulating layer capable of withstanding high programming and operating voltages is to be formed); and the exposed portions of layer 26 (over logic regions 10, 11) are etched (Figure 7).

An oxidizing step is then performed, which causes the growth of a roughly 10-15 nm thick gate oxide layer 28 at logic regions 10, 11, and increases the thickness of first gate oxide layer 26 to about 20-25 nm, as shown in Figure 8 in which the resulting oxide layer is indicated as a whole by 29; and a second polycrystalline silicon layer 30 is deposited to form the control gate regions of the memory cells and the gate regions of the logic and high-voltage transistors (Figure 8). Layer 30 is either phosphorous-doped in situ, or is first deposited and then implanted with phosphorous. Unlike the normal currently used method of fabricating flash memories, a tungsten silicide layer is not formed at this point, so that layer 30 is formed thicker, typically 25-35 nm, than in the known method, and is immediately masked to shape the gate regions of the transistors in logic and high-voltage regions 10-13. For this purpose, a masking layer 33 is deposited covering the whole of array region 9 and the portions of second polycrystalline silicon layer 30 forming the gate regions; and the exposed portions of layer 30 are removed by etching (Figure 9) using a different etching composition from the standard one used for flash memories, in view of the absence of the tungsten silicide layer.

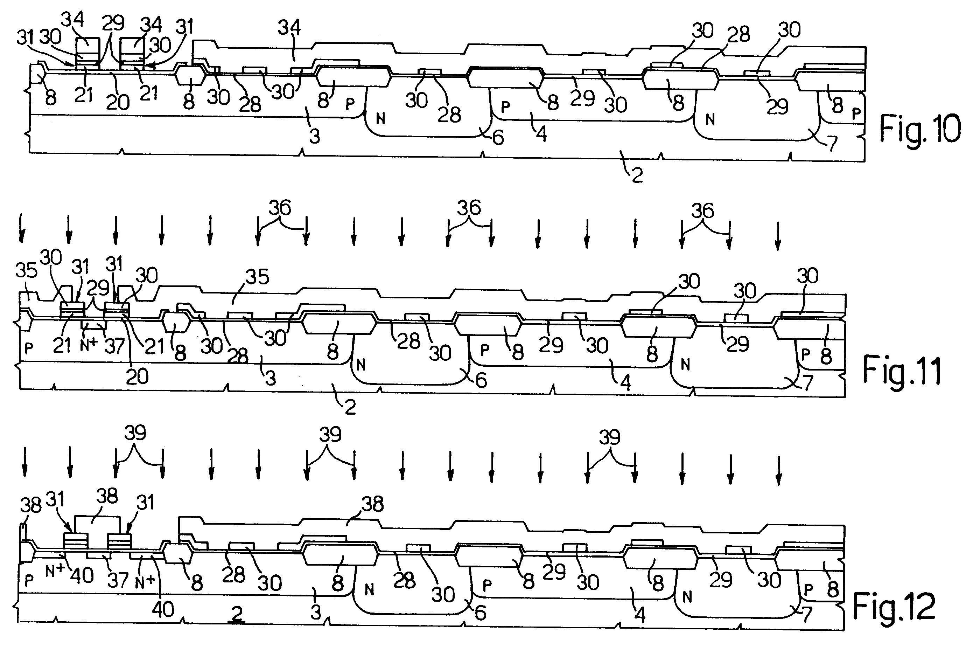

A mask is then formed to self-align etch memory region 9 and form stacks 31 comprising the control gate, interpoly dielectric and floating gate regions of the memory cells. For this purpose, a masking layer 34 is deposited covering the whole of logic and high-voltage regions 10-13, as well as strips of array region 9 (extending perpendicular to the drawing plane) where stacks 31 are to be formed; and the exposed portions of second polycrystalline silicon layer 30, of interpoly dielectric layer 29, and of first polycrystalline silicon layer 21 are removed (Figure 10), again using a different etching composition from the standard one used for flash memories.

A mask 35 is then deposited to implant the source regions of the memory cells, the mask covering the whole of logic and high-voltage regions 10-13 and the portions of memory region 9 not to be implanted; phosphorous and arsenic are implanted (as shown by arrows 36 in Figure 11) to form N⁺ type regions 37; mask 35 is removed; a mask 38 is deposited to implant the drain regions of the memory cells, so as to cover the whole of logic and high-voltage regions 10-13 and the portions of array region 9 not to be implanted (source regions 37); and arsenic is implanted (as shown by arrows 39 in Figure 12) to form N⁺ type drain regions 40.

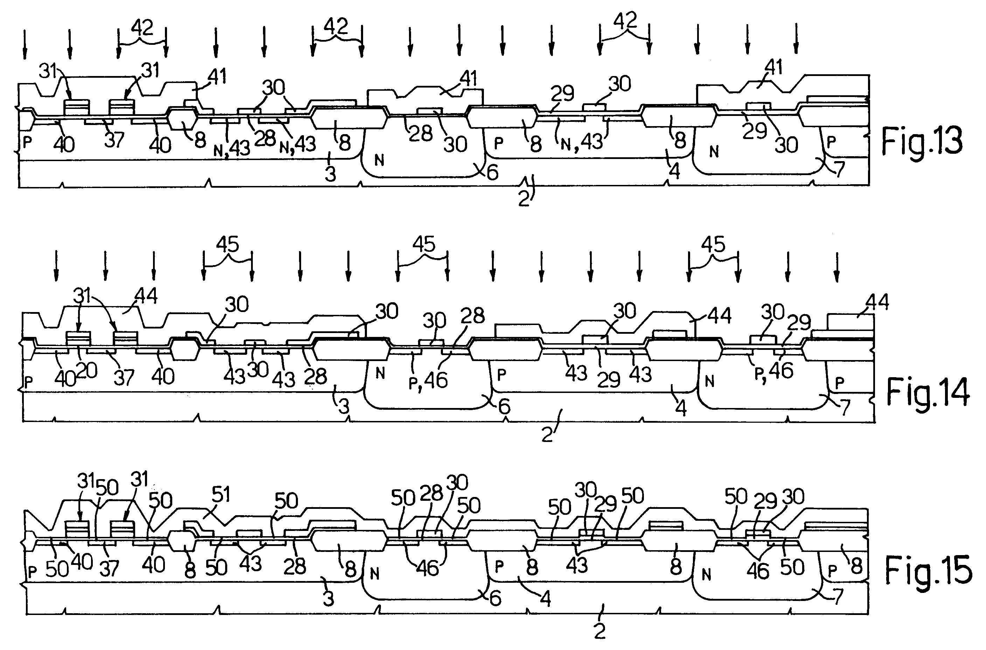

Mask 38 is then removed; a mask 41 is deposited to LDD implant the N-channel transistors and covers array region 9 and regions 11 and 13; an N type doping species is implanted (arrows 42) to form low-doped N type portions 43 of the source and drain regions of the N-channel transistors (Figure 13); mask 41 is removed; a mask 44 is deposited to LDD implant the P-channel transistors, and covers regions 9, 10 and 12; and a P type doping species is implanted (arrows 45) to form low-doped P type portion 46 of the source and drain regions of the P-channel transistors (Figure 14).

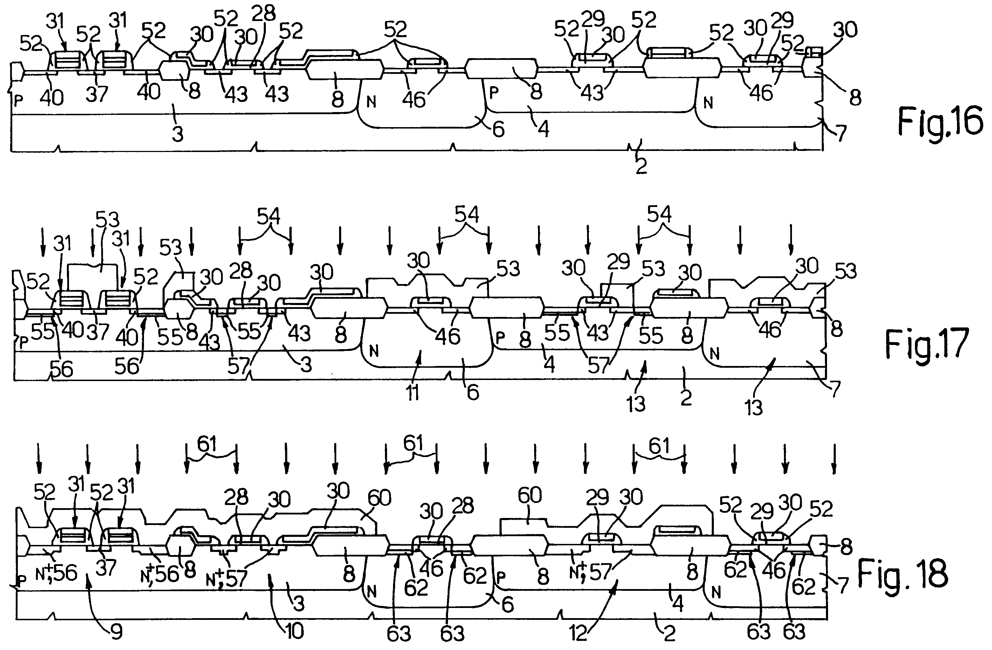

Once mask 44 is removed, the exposed residual oxides are eliminated (exposed portions of layers 20, 28, 29); and surface 15 is re-oxidized at the active areas of the device to form an oxide layer 50 (Figure 15). A layer 51 of dielectric material (normally SiO₂ deposited from TEOS-Tetraethylorthosilicate) is deposited to a thickness of about 250-400 nm; and reactive ion etching (RIE) is performed to form spacer regions 52 (Figure 16). A masking layer 53 is then deposited to form the N type source/drain regions, and covers source regions 37 of the cells, regions 11 and 13 relative to the P-channel transistors, and part of the drain region of the high-voltage N-channel transistors (region 12); and arsenic (e.g. of 4-5*10¹⁵ at/cm² concentration) is implanted, as shown by arrows 54, to form N⁺ type regions 55 partially superimposed on regions 40 and 43, and so form variable-doped regions indicated as a whole by 56 and 57 respectively (Figure 17).

A masking layer 60 is then deposited to form the P type source/drain regions; layer 60 covers array region 9 and regions 10, 12 relative to the N-channel transistors; and, using masking layer 60, boron or BF² (e.g. of 2.5-3.5*10¹⁵ at/cm² concentration) is implanted, as shown by arrows 61, to form P⁺ type regions 62 partially superimposed on regions 46, and so form variable-doped regions indicated as a whole by 63 (Figure 18).

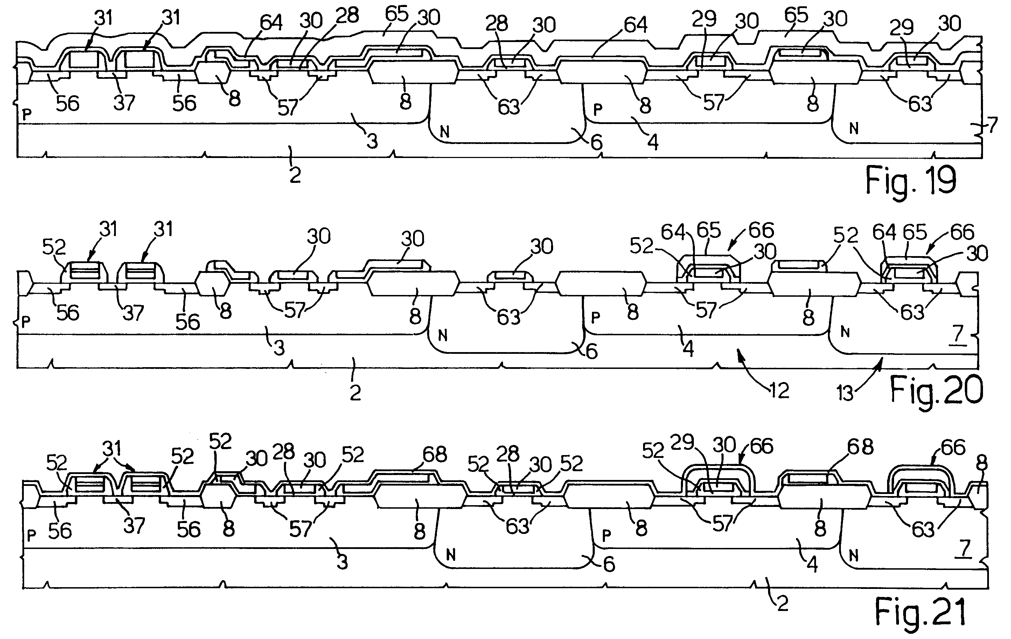

A thin (preferably 10-20 nm) oxide layer 64 is then deposited or grown; and a nitride layer 65 (preferably 50-100 nm) is deposited on layer 64 (Figure 19). To activate and diffuse the implanted doping species, heat treatment is then performed in an oven or using the rapid thermal process (RTP, in which the wafer is exposed to banks of lamps for generating a rapid rise and fall in temperature), which substitutes all the treatments over a temperature of 900°C performed in the standard flash memory fabrication method following formation of the junctions, e.g. to activate the doping species, which cannot be performed on the salicide without damaging it.

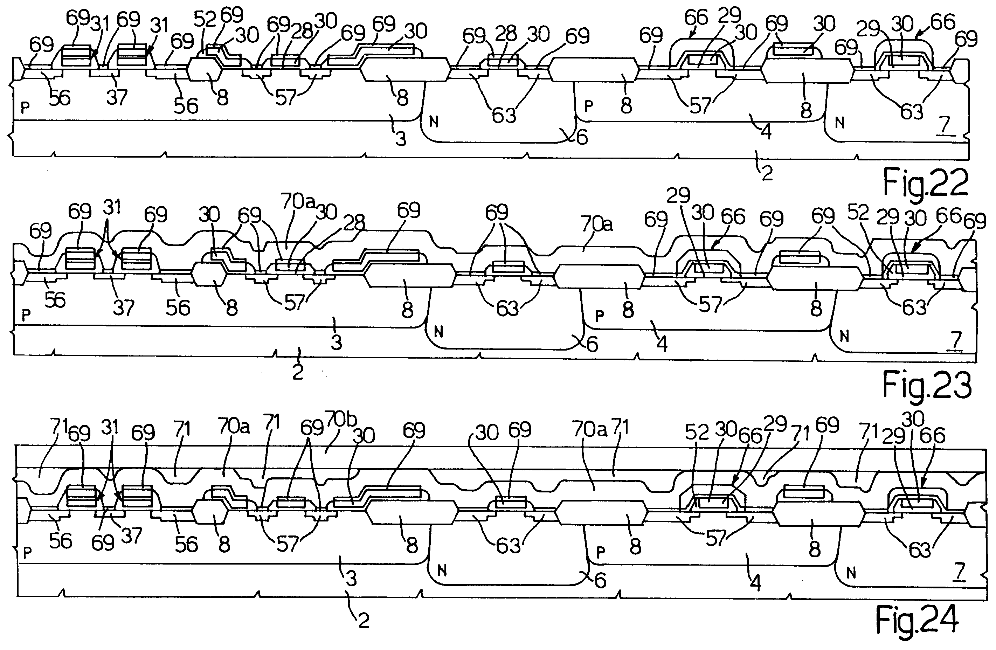

Using a resist mask (not shown), layers 64, 65 are shaped to in turn form a salicide protect mask 66 covering gate regions 30 and spacers 52 of the transistors formed in high-voltage regions 12 and 13, and, in general, the input protections, on the output buffers, and where resistances are to be formed (Figure 20).

After washing to remove the native oxide from the exposed surface of the silicon, a thin (30-50 nm) titanium layer 68 is deposited covering the whole of the exposed surface (Figure 21); and RTP annealing is performed at a temperature of 650-750°C to cause the titanium (layer 68) to react with the exposed underlying silicon, and so form titanium silicide portions on diffusions 37, 56, 57, 63 and on the portions of polycrystalline silicon layer 30 left exposed by mask 66. The nonreacting titanium is then removed using a solution of ammonia and hydrogen peroxide as shown in Figure 22 in which the titanium silicide portions are indicated by 69. Further RTP heat treatment is then performed at 800-950°C to convert the crystal phase of the titanium silicide to one with a lower resistivity.

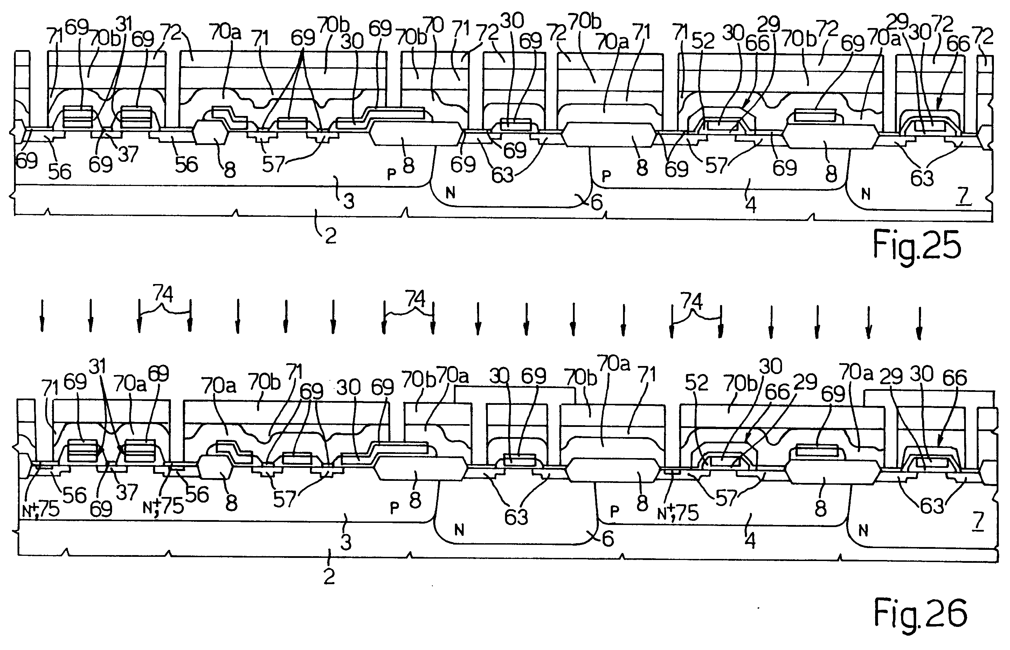

A first intermediate dielectric layer 70a is then deposited comprising an undoped oxide layer (e.g. TEOS) and heavily phosphorous-doped oxide layers, to prevent the diffusion of ions which might impair charge retention of the flash memory cells (Figure 23). First intermediate dielectric layer 70a is then planarized cold by depositing and etching a vitreous planarizing material such as SOG (spin-on glass) which only remains inside the cavities of first intermediate dielectric layer 70a (regions 71); and a heavily doped second intermediate dielectric layer 70b is deposited (Figure 24).

A contact mask 72 is then formed presenting windows at the portions of substrate 2 and polycrystalline silicon regions 30 to be contacted; and the exposed portions of planarizing layer 71 and intermediate dielectric layers 70a, 70b are etched using a selective etching solution with respect to the titanium silicide (Figure 25). After removing contact mask 72, a contact enriching mask 73 is formed covering regions 11 and 13; and N type doping species is implanted, as shown by arrows 74, to form enriched N⁺ type regions 75 in substrate 2 and polycrystalline silicon regions 30 (Figure 26).

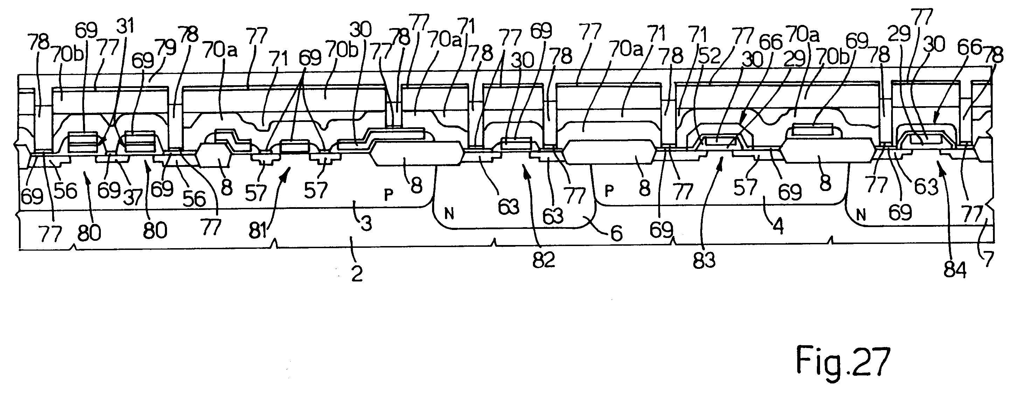

After removing mask 73 and a possible masking, implant and low-temperature (600-700°C) heat treatment step to enrich the contacts on the P regions and form P⁺ regions, a double barrier layer of titanium-titanium nitride (shown as a single layer 77 in Figure 27) is deposited by sputtering; a tungsten layer is chemical vapor deposited and reactive ion etched to form plugs 78 in the removed portions of intermediate dielectric layers 70a, 70b and planarizing layer 71 at the contacts; and a first metal level is formed by depositing layers of conducting material (e.g. aluminium, silicon, copper, titanium nitride) to form a first metal layer 79 (Figure 27).

In a manner not shown, metal layer 79 is then shaped; an intermetal dielectric layer is deposited and planarized; a second metal layer is deposited and shaped (if the process calls for multiple metal levels); and, finally, a passivation layer is deposited.

This therefore results in the formation of flash memory cells 80; N-channel circuit transistors 81; P-channel circuit transistors 82; high-voltage N-channel transistors 83; and high-voltage P-channel transistors 84.

Using the above method, a flash memory with logic circuitry was formed, and was found to present good programming and cycling properties compatible with insertion in complex logic circuits.

Clearly, changes may be made to the cell, the device and the fabrication method as described and illustrated herein without, however, departing from the scope of the present invention. In particular, numerous variations are possible of the embodiment described: for example, the order in which the implant steps are performed may be inverted; the masking and etching steps may be combined differently; the salicide layer may be replaced by a layer of different refractory material (such as cobalt and cobalt-titanium); the gate regions of the circuit and high-voltage transistors may be formed using DPCC technology (whereby the tunnel oxide and gate oxide are formed before depositing the first polycrystalline silicon layer, and the two polycrystalline silicon layers of the transistors are superimposed after first removing the interpoly dielectric layer, as described in US-A-4,719,184); the intermediate dielectric layer may be planarized differently (e.g. by rapid thermal processing the dielectric at low temperature, below 900°C); and additional implant steps may be performed to modify the electric characteristics or form particular regions.

## Claims

1. A flash-EEPROM memory cell (80) formed in a silicon substrate (2) housing conductivity regions (37, 56) and underlying a stack (31) of mutually aligned control layers; said stack including an upper silicon layer (30); characterized by salicide regions (69) overlying and contacting said conductivity regions (37, 56) and said upper silicon layer (30).

2. A cell as claimed in Claim 1, characterized in that said salicide regions (69) comprise a silicide of a refractory metal.

3. A cell as claimed in Claim 2, characterized in that said silicide is selected from titanium silicide, cobalt silicide and titanium-cobalt silicide.

4. An electronic device comprising transistors (81-83) and flash-EEPROM memory cells (80) formed in a silicon substrate (2) housing conductivity regions (37, 56, 57, 63); said transistors comprising control regions (30) overlying said substrate; said memory cells comprising stacks (31) of mutually aligned control layers overlying said substrate; and said control regions and said stacks of layers including at least an upper silicon layer (30); characterized by salicide regions (69) overlying and contacting said conductivity regions (37, 56, 57, 63) and said upper silicon layer (30).

5. A method of fabricating an electronic device as claimed in Claim 4 and comprising transistors and flash cells; the method comprising the steps of: forming cell and transistor conductivity regions (37, 56, 57, 63) inside a silicon substrate (2); forming control gate regions (30) over said substrate (2); and forming stacks (31) of mutually aligned control layers over said substrate; said control gate regions (30) and said stacks (31) of layers including at least an upper silicon layer (30); characterized by the step of forming metal salicide regions (69) over and contacting said conductivity regions and said upper silicon layer (30).

6. A method as claimed in Claim 5, characterized in that:
said step of forming stacks (31) of layers comprises the step of forming tunnel insulating regions (20), floating gate regions (21) of semiconductor material, interpoly insulating regions (29) and silicon cell gate regions (30) over said substrate (2);
said step of forming control gate regions (30) comprises the step of forming gate insulating regions (28, 29) over said substrate, and silicon transistor gate regions (30) over and aligned with said gate insulating regions (28, 29);
said step of forming conductivity regions (56, 57, 63) comprises the step of forming cell and transistor conductivity regions laterally offset with respect to said control gate regions (30) and said stacks (31) of layers; and
said step of forming metal salicide regions (69) comprises the steps of:
- depositing a metal layer (68) of a refractory metal on and contacting said cell and transistor conductivity regions (37, 56, 57, 63) and said silicon cell and transistor gate regions (30);
- causing said metal layer (68) to react with said cell and transistor conductivity regions (37, 56, 57, 63) and said silicon cell and transistor gate regions (30) to form metal silicide regions (69); and
- removing nonreacted portions of said metal layer.

7. A method as claimed in Claim 6, characterized in that said step of causing said metal layer to react comprises the step of annealing at a temperature of 600 to 800°C.

8. A method as claimed in Claim 6 or 7, characterized in that said step of removing nonreacted portions is followed by a heat treatment step to modify the crystal phase of said refractory metal.

9. A method as claimed in any one of the foregoing Claims from 6 to 8, characterized in that, prior to said step of depositing said layer of refractory metal, a salicide protection mask (66) is formed over predetermined portions of said substrate (2).

10. A method as claimed in any one of the foregoing Claims from 6 to 9, characterized in that said step of depositing said metal layer (68) is preceded by a heat treatment step to activate and diffuse doping species in said substrate (2).

11. A method as claimed in any one of the foregoing Claims from 6 to 10, characterized in that said step of removing nonreacted portions is followed by the steps of depositing a dielectric layer (70a) covering the whole of the exposed surface, and planarizing said dielectric layer by heat treatment at a temperature below 950°C.

12. A method as claimed in Claim 11, characterized in that said planarizing step comprises the steps of depositing and cold-etching a vitreous planarizing layer (71).

13. A method as claimed in Claim 11, characterized in that said planarizing step comprises an RTP heat treatment step.

14. A method as claimed in any one of the foregoing Claims from 7 to 13, characterized in that said step of depositing said metal layer (68) is preceded by the step of forming spacer regions (52) to the side of said stack (31) of layers.

15. A method as claimed in any one of the foregoing Claims from 7 to 14, characterized in that said metal silicide is selected from titanium silicide, cobalt silicide and titanium-cobalt silicide.
